# EUROPEAN PATENT APPLICATION

(11) **EP 4 593 088 A1**
(43) Date of publication of application: **30.07.2025**
(21) Application number: 23868501.0
(22) Date of filing: 15.09.2023
(51) Int. Cl.: H01L 31/0224, H01L 31/076, H01L 31/028, H01L 31/032, H10K 30/10, H01L 31/0687, H01L 31/18

(54) **TANDEM SOLAR CELL AND METHOD FOR MANUFACTURING SAME**

(30) Priority: 21.09.2022 KR 20220119088
(71) Applicant: Hanwha Solutions Corporation, Jung-gu Seoul 04541 (KR)
(72) Inventor: CHOI, In Young, Seoul 04541 (KR)
(74) Representative: Mooser, Sebastian Thomas
(86) International application number: PCT/KR2023/013903
(87) International publication number: WO 2024/063448

(57) **Abstract**

The present invention provides a tandem solar cell and a manufacturing method therefor. The tandem solar cell can increase horizontal resistance of a recombination layer connecting upper and lower cells of a tandem solar cell to minimize shunt path from being created, thereby preventing a drop in recombination efficiency due the problem of electron transfer, and can increase current value when applied to tandem-type solar cells due to low absorption in the short wavelength range.

## Description

### TECHNICAL FIELD

The present invention relates to a tandem solar cell, and more specifically relates to a tandem solar cell and a method for manufacturing the same, in which the horizontal resistance of a recombination layer connecting the upper and lower cells of a tandem solar cell can be reduced to minimize the occurrence of a shunt path, thereby reducing the recombination efficiency due to electron transfer problems, and which have low absorption in the short wavelength range, thereby improving the current value when applied to a tandem solar cell.

This application claims priority to and the benefit of Korean Patent Application No. 10-2022-0119088, filed on September 21, 2022, the disclosure of which is incorporated herein by reference in its entirety.

### BACKGROUND ART

Multi-junction (tandem) solar cells are an attempt to minimize thermalization loss by effectively using solar energy in a wide wavelength range by vertically stacking light absorption layers with different band gaps. Specifically, tandem solar cells allow light absorption layers with different band gaps to absorb sunlight by dividing the same into wavelength regions such that when photons with energy greater than the band gap in a single-junction solar cell are absorbed by the light absorption layer, the efficiency limit of single-junction solar cells can be overcome with a principle of minimizing the loss of excess energy of electrons and holes as heating energy. Recently, since interest in tandem solar cells as the most feasible next-generation solar cell has increased, research and development competition to dominate tandem solar cell technology with various structures is intensifying around the world.

Meanwhile, in such tandem solar cells, a transparent conductive thin film (TCO) is mainly used as a recombination layer that electrically connects a silicon lower cell and a perovskite upper cell. Transparent conductive thin films have a characteristic that when the concentration of free charges is low, grain boundary scattering caused by the energy barrier (potential barrier) formed by free charges trapped at grain boundaries plays a significant role, resulting in extremely low mobility of free charges. On the other hand, if the concentration of free charges is large, the number of free charges that can overcome the energy barrier formed at the grain boundary increases, and thus, the mobility of free charges can increase to some extent. In this case, if the concentration of free charges increases above a certain level, as ionized impurities present in the thin film increase, scattering between free charges and ionized impurities may occur, resulting in a decrease in the mobility of free charges.

In order to compensate for this problem, various studies have been conducted as a method of increasing the free charge concentration in transparent conductive thin films used as recombination layers in tandem solar cells by doping cationic metal elements to generate free charges and to control the free charge concentration by adjusting the doping amount. In addition, conventional tandem solar cells use ITO with a ratio of 10 wt% SnO₂ and 90 wt% In₂O₃ or IZO with a ratio of 10 wt% ZnO₂ and 90 wt% In₂O₃, which have high electrical conductivity, as a transparent conductive thin film in the recombination layer.

However, in the case of a recombination layer with such a ratio, the electrical resistance is low, and thus, electrons can be moved efficiently, but there is a limit to improving the efficiency of tandem solar cells due to the following problems.

Firstly, in the case of a tandem solar cell in which a conventionally introduced transparent conductive thin film having the above ratio is used as a recombination layer, there is a problem in that a shunt path is created and loss occurs. That is, in the case of a tandem solar cell in which the lower silicon cell and the upper perovskite layer are connected in series through a recombination layer, if the horizontal electrical conductivity of the recombination layer is low, charges flow horizontally and create a shunt path, thereby causing electrical loss. Due to this electrical loss, there are limits to improving the efficiency of solar cells.

Secondly, when ITO with a ratio of 10 wt% In₂O₃ is used as a transparent conductive thin film of the recombination layer, there is a limit to minimizing optical loss because the optical absorption increases because absorption phenomena occur in the visible light range by ionized impurities and free carrier absorption phenomena occur in the long wavelength range of visible light and near-infrared range. In other words, there is a problem in that a tandem solar cell having a structure in which the upper cell with a large band gap absorbs solar energy in a low wavelength range and the lower cell with a low band gap absorbs solar energy in a high wavelength range has limitations in reducing optical loss, thereby making it impossible to operate solar energy in a wide wavelength range.

Accordingly, by exhibiting higher sheet resistance, lower electrical conductivity and lower electron mobility in the recombination layer connecting the upper and lower cells of a tandem solar cell compared to the prior art, it is possible to minimize efficiency reduction due to the shunt path, thereby preventing recombination reduction and efficiency degradation due to restricted horizontal movement of electrons. In addition, since it has low absorption in the short wavelength band, it is expected that the current value will be improved when applied to tandem solar cells. Therefore, research on tandem solar cells that can improve the efficiency of tandem solar cells is urgently needed.

### DISCLOSURE

### TECHNICAL PROBLEM

The present invention has been devised to overcome the above-described problems, and the problem to be solved by the present invention is to provide a tandem solar cell and a method for manufacturing the same, which can minimize efficiency reduction due to a shunt path by increasing horizontal resistance by using a transparent conductive thin film element having a specific ratio as a recombination layer connecting the upper and lower cells of the tandem solar cell.

In addition, another problem to be solved by the present invention is to provide a tandem solar cell and a method for manufacturing the same, which can prevent a decrease in recombination and a decrease in efficiency due to the restricted movement of electrons, and it is possible to improve the efficiency of a tandem solar cell by expecting an improvement in the current value when applied to a tandem solar cell due to low absorption in a short wavelength band.

### TECHNICAL SOLUTION

In order to solve the above-described problems, provided is a tandem solar cell, including a silicon lower cell; a perovskite upper cell; and a recombination layer connecting the silicon lower cell and the perovskite upper cell, wherein the recombination layer includes ITO that is a transparent conductive thin film, and the ITO includes SnO₂ and In₂O₃ at a weight ratio of 18 to 21: 79 to 82.

In addition, according to an embodiment of the present invention, the thickness of the transparent conductive thin film may be 5 to 50 nm.

In addition, the sheet resistance of the transparent conductive thin film may be 50 ohm/sq to 1M ohm/sq.

In addition, the silicon lower cell may be any one selected from the group consisting of Al-BSF, PERC, PERT, PERL and TOPCon structures.

In addition, the transparent conductive thin film may have an electrical conductivity of 600 1/ ohm·cm to 1,200 1/ ohm·cm.

In addition, wherein the transparent conductive thin film may have an electron mobility of 60 cm³/Vs to 120 cm³/Vs.

In addition, the present invention provides a method for manufacturing a tandem solar cell, including step 1 of forming a recombination layer on an upper surface of a silicon lower cell; and step 2 of forming a perovskite upper cell that is connected to the silicon lower cell through the recombination layer, wherein the recombination layer includes ITO that is a transparent conductive thin film, and the ITO includes SnO₂ and In₂O₃ at a weight ratio of 18 to 21: 79 to 82.

Meanwhile, the present invention was researched with support from the following Korean research and development projects.
1. [National Research and Development Project That Supported This Invention]
   [Project Identification Number] 1415174234
   [Project Number] 20203040010320
   [Name of Ministry] Ministry of Trade, Industry and Energy
   [Name of Project Management (Specialized) Institution] Korea Institute of Energy Technology Evaluation and Planning
   [Title of Research Project] New and renewable energy core technology development
   [Title of Research Task] Development of 6-inch perovskite/crystalline silicon-
      tandem solar cell manufacturing technology with 26% efficiency for increased power generation
   [Contribution Ratio] 1/2
   [Name of Task Performance Institution] Hanwha Solutions Co., Ltd.
   [Research Period] January 1, 2022 to December 31, 2022
2. [National Research and Development Project That Supported This Invention]
   [Project Identification Number] 1415176482
   [Project Number] 20213030010400
   [Name of Ministry] Ministry of Trade, Industry and Energy
   [Name of Project Management (Specialized) Institution] Korea Institute of Energy Technology Evaluation and Planning
   [Title of Research Project] New and renewable energy core technology development (R&D)
   [Title of Research Task] Development of high-efficiency-
      perovskite/crystalline silicon tandem solar module process technology with high durability
   [Contribution Ratio] 1/2
   [Name of Task Performance Institution] Hanwha Solutions Co., Ltd.
   [Research Period] May 1, 2022 to December 31, 2022

### ADVANTAGEOUS EFFECTS

The present invention can increase horizontal resistance by exhibiting high sheet resistance, low electrical conductivity and low electron mobility compared to the prior art in a recombination layer connecting the upper and lower cells of a tandem solar cell, thereby minimizing a decrease in efficiency due to a shunt path, and it can prevent a decrease in recombination and a decrease in efficiency due to the restriction of electron movement, and as it has low absorption in the short wavelength range, it is possible to expect an improvement in current value when applied to a tandem solar cell, thereby improving the efficiency of a tandem solar cell.

### DESCRIPTION OF DRAWINGS

FIG. 1 is a mimetic diagram showing a tandem solar cell device according to an embodiment of the present invention.
FIG. 2 is a graph showing the transparent conductive thin film characteristics of the recombination layers according to an embodiment and comparative example of the present invention.
FIG. 3 is a graph showing the cell efficiency of a tandem solar cell device according to an embodiment and a comparative example of the present invention.

### MODES OF THE INVENTION

Hereinafter, embodiments of the present invention will be described in detail so that those skilled in the art can easily practice the present invention. The present invention may be implemented in many different forms and is not limited to the embodiments described herein.

As described above, there is a limit to improving the efficiency of a conventional tandem solar cell due to the electrical/optical loss of a transparent conductive thin film used in the recombination layer connecting the upper and lower cells.

Accordingly, in order to solve the above-described problems, the present invention has attempted to solve the above-described problems by providing a tandem solar cell, including a silicon lower cell, a perovskite upper cell and a recombination layer connecting the silicon lower cell and the perovskite upper cell, wherein the recombination layer is ITO, which is a transparent conductive thin film, and has a weight ratio of SnO₂ and In₂O₃ of 18 to 21: 79 to 82.

Through this, the present invention can increase horizontal resistance by exhibiting high sheet resistance, low electrical conductivity and low electron mobility compared to the prior art in the recombination layer connecting the upper and lower cells of a tandem solar cell, thereby minimizing a decrease in efficiency due to a shunt path, and it is possible to prevent a decrease in recombination and a decrease in efficiency due to limitation of electron movement, and as it has a low absorption in the short wavelength range, an improvement in current value can be expected when it is applied to a tandem solar cell, and thus, it is possible to improve the efficiency of tandem solar cells.

Within the present specification, the lower cell refers to a silicon solar cell formed at the bottom of a tandem solar cell, and the upper cell refers to a perovskite solar cell formed at the top of a tandem solar cell.

Additionally, within the present specification, a silicon lower cell refers to a solar cell including silicon as a light absorption layer, and a perovskite upper cell refers to a solar cell including a material having a perovskite structure as a light absorption layer.

Hereinafter, the tandem solar cell device according to the present invention will be described in detail with reference to the drawings.

The tandem solar cell device 100 according to the present invention includes a silicon lower cell 200, a perovskite upper cell 400 and a recombination layer 300 connecting the silicon lower cell 200 and the perovskite upper cell 400.

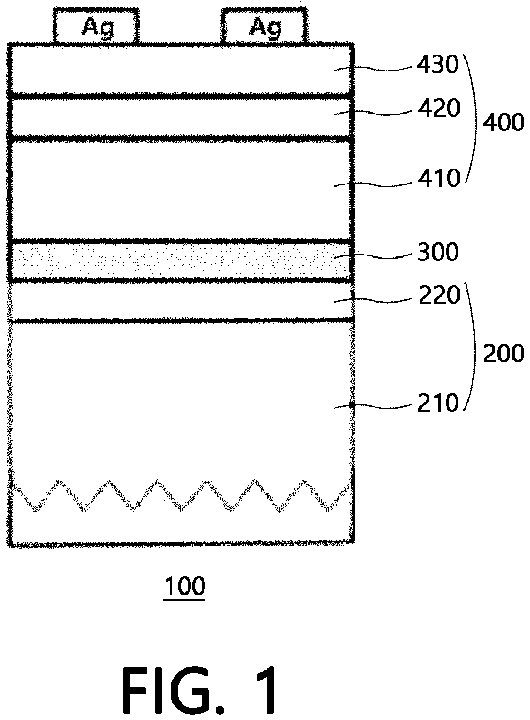

The silicon lower cell 200 may be formed on an upper surface of a front electrode as shown in FIG. 1 and may include a silicon layer 210 and an emitter layer 220 disposed on the silicon layer 210.

The silicon layer 210 may have one of the structures of known silicon solar cells, and is not limited to a specific structure. For example, the silicon layer 210 may include a crystalline silicon substrate (not shown), a p-type amorphous or crystalline silicon layer (not shown), an n-type amorphous or crystalline silicon layer (not shown), or an amorphous intrinsic silicon layer (not shown), and although not shown in the drawing, additional layers may be included as needed.

According to a preferred embodiment of the present invention, the structure of the silicon lower cell 200 may become structures such as Al-BSF (Aluminum Back Surface Field) through n⁺⁺ emitter formation on the p-type silicon surface, PERC (Passivated Emitter and Rear Cell), PERT (Passivated Emitter Rear Totally diffused) and PERL (Passivated Emitter and Rear Locally diffused) structures, or TOPCon (Tunnel oxide passivated contact) structure through SiOx tunneling layer/n⁺⁺ poly-Si formation and the like, and it is not particularly limited.

Meanwhile, at least a portion of one surface or the other surface of the silicon layer 210 may be textured to improve light efficiency. That is, an uneven surface (not shown) is formed in a direction in which light enters, and the light scattering effect of light that is incident through the uneven surface increases the path of light that is incident on the silicon layer 210 to improve light collection, thereby increasing the absorption rate of solar light.

Next, the recombination layer 300 serves as an intermediate layer that physically bonds and electrically connects the silicon lower cell 200 and the perovskite upper cell 400, and it may perform charge recombination of the upper and lower cells.

Conventionally, a typical tandem solar cell has attempted to improve the electrical/mechanical stability of the tandem solar cell by improving the interfacial characteristics of the recombination layer. For this purpose, the conventional recombination layer uses a conductive material with light transparency, and for example, TCO-based materials such as ITO (Indium Tin Oxide), ICO (Indium Cerium Oxide), IWO (Indium Tungsten Oxide), ZITO (Zinc Indium Tin Oxide), ZIO (Zinc Indium Oxide), ZTO (Zinc Tin Oxide), GITO (Gallium Indium Tin Oxide), GIO (Gallium Indium Oxide), GZO (Gallium Zinc Oxide), AZO (Aluminum doped Zinc Oxide), FTO (Fluorine Tin Oxide), ZnO and the like are used or a nc-Si:H material layer is used.

Particularly, in order to control the free charge concentration and improve the efficiency of tandem solar cells, ITO with a ratio of 10 wt% SnO₂ and 90 wt% In₂O₃ or IZO with a ratio of 10 wt% ZnO₂ and 90 wt% In₂O₃, which is doped with cationic metal elements and has a controlled doping amount, is mainly used as a transparent conductive thin film of the recombination layer.

However, in the case of tandem solar cells in which the previously introduced transparent conductive thin film with the corresponding ratio is used as a recombination layer, there is a problem in that a shunt path is created and loss occurs, and furthermore, there is a limit to minimizing optical loss because free carrier absorption occurs in the long-wavelength range of visible light and the near-infrared range, which increases light absorption.

Accordingly, the present invention has solved the above-described problems by forming SnO₂ and In₂O₃ of ITO, which is the recombination layer 300, into a transparent conductive thin film having a weight ratio of 18 to 21: 79 to 82.

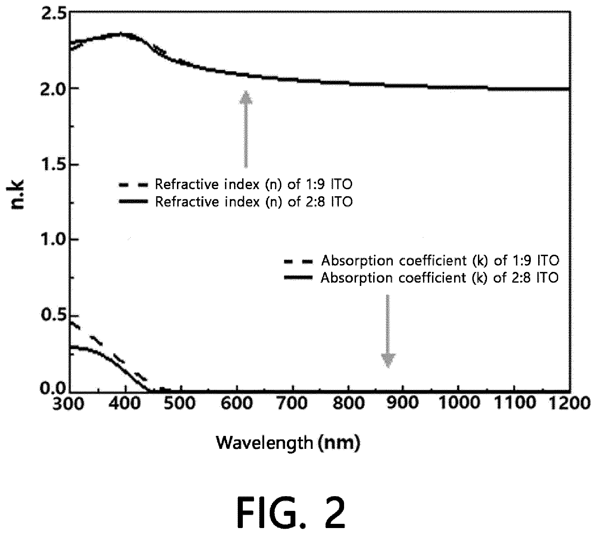

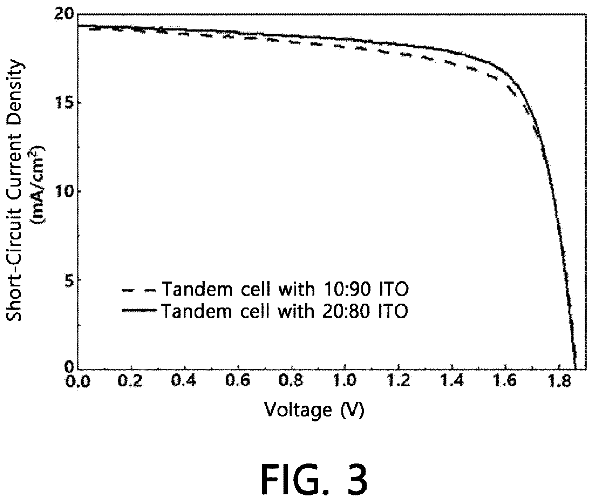

More specifically, referring to Table 2 and FIG. 2, it can be seen that Example 1 that was manufactured with a transparent conductive thin film corresponding to the above-described numerical range had a higher sheet resistance, lower conductivity and electron mobility compared to a comparative example corresponding to a transparent conductive thin film of a conventional general weight ratio. In addition, referring to Table 3 and FIG. 3, it can be seen that the example that was manufactured with a transparent conductive thin film corresponding to the preferred numerical range of the present invention had JSC and FF that were improved at the same thickness compared to the comparative example corresponding to a transparent conductive thin film of a conventional general weight ratio.

Through this, the recombination layer 300 according to the present invention is ITO, which is a transparent conductive thin film, and it can be seen that the tandem solar cell may efficiently perform its role as a recombination layer that physically/electrically connects the upper/lower cells and performs charge recombination only when SnO₂ and In₂O₃ are implemented to have a weight ratio of 18 to 21: 79 to 82.

In this case, if the transparent conductive thin film including SnO₂ at a weight ratio of less than 18 or more than 21 in the weight ratio of SnO₂ and In₂O₃ of ITO, which is the recombination layer 300, is used as a recombination layer 300, the carrier concentration and electron mobility of the recombination layer 300 are greatly reduced, thereby making it difficult to move electrons generated in the lower cell, and thus, there may be a problem in that it cannot efficiently perform its role as a recombination layer.

Meanwhile, the thickness of the transparent conductive thin film forming the recombination layer 300 may be 5 to 50 nm, and more preferably, 10 nm to 30 nm. If the thickness of the transparent conductive thin film forming the recombination layer 300 exceeds 50 nm, there may be a problem of current loss due to increased parasitic absorption and a decrease in efficiency due to a shunt path as a result of a decrease in horizontal resistance. Additionally, if the thickness of the transparent conductive thin film forming the recombination layer 300 is less than 5 nm, reduced recombination and reduced efficiency may occur due to limited electron movement.

In addition, the sheet resistance of the transparent conductive thin film forming the recombination layer 300 may be 50 ohm/sq to 1 Mohm/sq, and preferably, 100 ohm/sq or more. In this case, if the sheet resistance of the transparent conductive thin film forming the recombination layer 300 is less than 50 ohm/sq, a decrease in efficiency may occur due to an increase in the shunt path as a result of a decrease in horizontal resistance, as can be seen from FIG. 2 and Table 1 below. Meanwhile, when the sheet resistance of the thin film exceeds 1 Mohm/sq, electrical conductivity in the vertical direction is significantly reduced, which may limit electron movement, resulting in reduced recombination and reduced efficiency.

That is, as the present invention implements the recombination layer 300 of a tandem solar cell with a transparent conductive thin film having the above specific weight ratio, it is possible to manufacture a transparent conductive thin film having an electrical conductivity of 600 1/ohm·cm to 1,200 1/ohm·cm, and more preferably, a low electrical conductivity of 700 1/ohm·cm to 1,100 1/ohm·cm. Due to the effect of such low electrical conductivity, the present invention may be characterized by implementing a transparent conductive thin film with a low electron mobility of 60 cm³/Vs to 120 cm³/Vs, and more preferably, 70 cm³/Vs to 110 cm³/Vs.

Through this, the present invention may minimize a decrease in efficiency due to a shunt path by increasing the horizontal resistance, and also prevent decreases in recombination and efficiency due to limitation of electron movement, and may exhibit low absorption in the short wavelength range. Therefore, it is possible to expect an improvement in the current value of the tandem solar cell, thereby improving the efficiency of a tandem solar cell.

That is, referring to FIG. 3, according to a preferred embodiment of the present invention, in the case of the TOP Perc/perovskite tandem device manufactured by electrically connecting the upper and lower devices by depositing a 20 wt% SnO₂:80 wt% In₂O₃ ITO thin film on a lower n⁺⁺ emitter layer as the recombination layer 300, it can be seen that it has improved JSC and FF at the same thickness compared to the structure in which a conventional structure of 10 wt% SnO₂:90 wt% In₂O₃ ITO thin film is applied as the recombination layer.

Next, the perovskite upper cell 400 is an upper cell which is in contact with the silicon lower cell 200, and a perovskite absorption layer 410, an electron transport layer 420 and a transparent conductive oxide electrode layer 430 may be stacked.

The perovskite absorption layer 410 may be formed such that hole-electron pairs generated by receiving light energy from the sun can be separated into electrons or holes. In one embodiment, electrons formed in the perovskite absorption layer 410 may be transferred to the electron transport layer 420, and holes formed in the perovskite absorption layer 410 may be transferred to the hole transport layer.

In this case, the perovskite absorption layer 410 may include an organic halide perovskite such as methyl ammonium iodide (MAI), formamidinium iodide (FAI), or a metal halide perovskite such as lead iodide (PbI₂), bromine iodide (PbBr) and lead chloride (PbCl₂). That is, the perovskite absorption layer 410 may be a multi-layered stacking structure including at least one of organic halide perovskite or metal halide perovskite. More specifically, the perovskite absorption layer 410 may be represented by AMX₃ (where A is a monovalent organic ammonium cation or metal cation; M is a divalent metal cation; and X is a halogen anion). As non-limiting examples thereof, CH₃NH₃PbI₃, CH₃NH₃PbIₓCl₃₋ₓ, CH3NH₃PbIxBr₃₋ₓ, CH₃NH₃PbClₓBr₃₋ₓ, HC(NH₂)₂PbI₃, HC(NH2)₂PbIxCl₃₋ₓ, HC(NH2)2PbIxBr3-x, HC(NH₂)₂PbClₓBr₃₋ₓ, (CH₃NH₃)(HC(NH₂)₂)_{1-y}PbI₃, (CH₃NH₃)(HC(NH₂)₂)_{1-y}PbIₓCl₃-ₓ, (CH₃NH₃)(HC(NH₂)₂)_{1-y}PbIₓBr₃₋ₓ, or (CH₃NH₃)(HC(NH₂)₂)_{1-y}PbClₓBr₃₋ₓ may be used (0=x, y=1).

The electron transport layer 420 serves to separate and transport electrons formed in the perovskite absorption layer 410, and may be formed of a known or conventional material as long as it meets the purpose of the present invention. As non-limiting examples thereof, Ti oxide, Zn oxide, In oxide, Sn oxide, W oxide, Nb oxide, Mo oxide, Mg oxide, Zr oxide, Sr oxide, Yr oxide, La oxide, V oxide, Al oxide, Y oxide. , Sc oxide, Sm oxide, Ga oxide, In oxide and SrTi oxide may be used.

Although the tandem solar cell device according to the present invention has been described above, this is only an example and may further include an additional stacking structure that can improve solar cell efficiency.

The present invention will be described in more detail through examples below, but the following examples do not limit the scope of the present invention, and should be interpreted to aid understanding of the present invention.

### Example 1 - Manufacture of tandem solar cell device

For a lower solar cell, a PERC structure cell in which an n⁺⁺ emitter layer is formed through the POCl process on a p-type impurity-doped silicon substrate on which a lower passivation layer and lower electrode are formed, which are being manufactured by Hanwha Q CELLS, was used.

Next, an ITO (Indium Tin Oxide) layer with a thickness of 50 nm was formed as a recombination layer on top of the n⁺⁺ emitter layer by using a sputtering device.

Afterwards, a 20 wt% SnO₂ : 80 wt% In₂O₃ ITO thin film was deposited on the n⁺⁺ emitter layer to form a recombination layer with a thickness of 20 nm that electrically connects the upper/lower devices. Thereafter, NiOₓ was formed as a hole transport layer under high vacuum conditions using the E-beam deposition method, and then, IZO (Indium doped Zinc Oxide) was formed as a transparent electrode layer with a thickness of 100 nm on top of the hole transport layer using sputtering equipment.

Next, a TOPPerc/perovskite tandem device was manufactured by forming silver (Ag) on the top of the transparent electrode layer to a thickness of 200 nm using a thermal evaporator under high vacuum conditions.

In this case, in the case of 20 wt% SnO₂ : 80 wt% In₂O₃ ITO thin film, it may have a Sn/In ratio of 18 wt% to 21 wt% depending on the formation atmosphere, formation method and post-treatment method.

### Comparative Example 1

Except that in Example 1, a thin film was deposited with 10 wt% SnO₂ : 90 wt% In₂O₃ ITO which is a conventional numerical range and a recombination layer that electrically connected the upper and lower elements was formed to a thickness of 20 nm, a TOPPerc/perovskite tandem device was manufactured in the same manner as Example 1.

### Experimental Example 1 - Evaluation of properties of transparent conductive thin films

The thin film composition ratio of the recombination layers of Examples 1 and 2 was evaluated using XPS analysis equipment, and the results are shown in Table 1 below.

Referring to Table 1 below, in the case of 20 wt% SnO₂ : 80 wt% In₂O₃ ITO thin film according to Example 1 according to the present invention, it can be seen that it has a Sn/In ratio between 18 wt% and 21 wt% depending on the formation atmosphere and formation method of the thin film and the post-treatment method.

**[Table 1]**

| SnO₂ : In₂O₃ Weight Ratio | In | Sn | O | O/In | Sn/In |
|---|---|---|---|---|---|
| 1:9 | 34.5 | 3.5 | 52.7 | 1.53 | 0.101 |
| 2:8 | 30.3 | 5.7 | 53.8 | 1.78 | 0.188 (18.8wt%) |

### Experimental Example 2 - Evaluation of properties of transparent conductive thin films

The properties of thin films were evaluated for Example 1 and Comparative Example 1, and the results are shown in Table 2 and FIG. 2 (the vertical axis n in FIG. 2 refers to a refractive index, and k refers to an absorption coefficient).

Referring to Table 2 and FIG. 2 below, in the case of Example 1 that was manufactured with a transparent conductive thin film corresponding to the preferred numerical range of the present invention, the sheet resistance (ohm/sq) was higher than the comparative example corresponding to a transparent conductive thin film having a conventional general weight ratio, and it can be seen that it had low conductivity (1/ohm·cm) and electron mobility (cm³/Vs).

**[Table 2]**

| ITO Target (SnO₂:In₂O₃ Weight Resistance) | Sheet Resistance (ohm/sq) | Bulk Concentration (Bulk Con., /cm³) | Conductivity (1/ohm:cm) | Electron Mobility (cm³/Vs) |
|---|---|---|---|---|
| 1:9 | 216~228 | 6.62E+19 | 2082 | 196 |
| 2:8 | 560~678 | 6.11E+19 | 859 | 88 |

### Experimental Example 3 - Evaluation of solar cell efficiency

The photoelectric efficiency of the tandem solar cell devices according to Example 1 and Comparative Example 1 was measured under AM1.5G light conditions using solar simulator equipment, and the results are shown in Table 3 and FIG. 3 below.

Referring to Table 3 and FIG. 3 below, in the case of the example that was manufactured with a transparent conductive thin film corresponding to the preferred numerical range of the present invention, it can be seen that it had much improved short-circuit current density (J_{SC}) and fill factor (FF) at the same thickness compared to the comparative example corresponding to a conventional transparent conductive thin film with a general weight ratio.

**[Table 3]**

| ITO Target | IV(best) | | | |
|---|---|---|---|---|
| (SnO₂:In₂O₃ Weight Ratio) | Open-Circuit Voltage (V_{oc}, V) | Short-Circuit Current Density (J_{sc}, mA/cm²) | Fill Factor (FF) | Photoelectric Conversion Efficiency (EFFᵣₑᵥ, %) |
| 1:9 | 1.863 | 19.20 | 71.62 | 25.63 |
| 2:8 | 1.859 | 19.34 | 74.23 | 26.68 |

Summarizing these results, the present invention can increase horizontal resistance by exhibiting high sheet resistance, low electrical conductivity and low electron mobility in the recombination layer connecting the upper and lower cells of a tandem solar cell compared to the prior art, thereby minimizing a decrease in efficiency due to a shunt path. In addition, it is possible to prevent a decrease in recombination and a decrease in efficiency due to electron movement restrictions, and as it has low absorption in the short wavelength range, it is expected that the current value will be improved when it is applied to tandem solar cells, and thus, it can be seen that the efficiency of tandem solar cells can be improved.

## Claims

1. A tandem solar cell, comprising:
a silicon lower cell;
a perovskite upper cell; and
a recombination layer connecting the silicon lower cell and the perovskite upper cell,
wherein the recombination layer comprises ITO that is a transparent conductive thin film, and the ITO comprises SnO₂ and In₂O₃ at a weight ratio of 18 to 21: 79 to 82.

2. The tandem solar cell of claim 1, wherein the thickness of the transparent conductive thin film is 5 to 50 nm.

3. The tandem solar cell of claim 1, wherein the sheet resistance of the transparent conductive thin film is 50 ohm/sq to 1M ohm/sq.

4. The tandem solar cell of claim 1, wherein the silicon lower cell is any one selected from the group consisting of Al-BSF, PERC, PERT, PERL and TOPCon structures.

5. The tandem solar cell of claim 1, wherein the transparent conductive thin film has an electrical conductivity of 600 1/ohm·cm to 1,200 1/ohm·cm.

6. The tandem solar cell of claim 1, wherein the transparent conductive thin film has an electron mobility of 60 cm³/Vs to 120 cm³/Vs.

7. A method for manufacturing a tandem solar cell, comprising:
step 1 of forming a recombination layer on an upper surface of a silicon lower cell; and
step 2 of forming a perovskite upper cell that is connected to the silicon lower cell through the recombination layer,
wherein the recombination layer comprises ITO that is a transparent conductive thin film, and the ITO comprises SnO₂ and In₂O₃ at a weight ratio of 18 to 21: 79 to 82.
